# EUROPEAN PATENT SPECIFICATION

(11) **EP 2 368 930 B1**
(45) Date of publication and mention of the grant of the patent: **25.02.2015**
(21) Application number: 10157150.3
(22) Date of filing: 22.03.2010
(51) Int. Cl.: C08G 59/68, C08L 61/06, C08L 63/00, H01L 23/29

(54) **Novel low dielectric resin varnish composition for laminates and the preparation thereof**
Nouvelle composition de vernis de résine faiblement diélectrique pour stratifiés et sa préparation
Neue Harzlackzusammensetzung mit niedriger Dielektrizitätskonstante für Laminate und Herstellung davon

(43) Date of publication of application: 28.09.2011
(73) Proprietor: Nan-Ya Plastics Corporation, Taipei (TW)
(72) Inventor: Tzou, Ming-Jen, Songshan District Taipei (TW); Lu, Jung-Che, Songshan District Taipei (TW); Lin, Yi-Cheng, Songshan District Taipei (TW)
(74) Representative: Viering, Jentschura & Partner Patent- und Rechtsanwälte

(56) References cited:
- US-A1- 2005 267 286
- US-A1- 2007 244 267
- US-A1- 2008 118 633

## Description

### FIELD OF THE INVENTION

The invention concerns a resin varnish composition with low dielectric constant, high thermal stability, low moisture absorption and superior fire retardance, which can meet UL94 V-0 flame retardant test for new laminates used in high-performance circuit boards.

### BACKGROUND OF THE INVENTION

With the rapid technological advances, many of the computer information industry, communication and consumer electronic products are changing very fast. Looking at the entire electronics industry, the development features are:
1. Increasingly high application frequency,
2. Higher and higher manufacturing technology level.

As for printed circuit boards, the direction of development is becoming low dielectric, low thermal expansion, multi-layer, high thermal resistance and so on, meanwhile complying with environment-friendly requirements. Electronics and communication products also tend to be light, thin, short and to meet high-reliability, multi-function and environmental protection requirements. Since the high-frequency technology is being used in the wireless networks and communication equipments, the demand for high-frequency substrates is bound to become the future trend of development. In short, high-frequency communication substrate materials used require nothing more than to send data quickly and not to cause data loss or interference in the process of transmission. Therefore, high-frequency communication equipments selected in production must have the following basic features:
(1) Small and stable dielectric constant,
(2) Low dissipation factor,
(3) Low water absorption,
(4) Good chemical resistance,
(5) Good thermal resistance.

The electrical characteristics of the printed circuit board material depend on the three main composite material types of the substrate: (i) resin, (ii) filler, and (iii) reinforcement materials. As for the resin system, the current used FR-4 (Tg140 °C) substrate made from the combination of epoxy resin (such as Nan Ya's NPEB454A80) and glass fiber (E glass) shows a "dielectric constant" (abbreviated as Dk) value of 4.6 only, which cannot meet the requirements in the field of the high frequency transmission. Different resin systems (such as "bismaleimide triazine" resin (abbreviated as BT), cyanate ester resin, PTFE resins (Polytetrafluoroethylene) and so on are gradually developed, but the new developed resin system shows big deviations from the current substrate manufacturing and processing conditions, and can not be used in the existing equipments, thus it can not be widely applied.

### SUMMARY OF THE INVENTION

The scope of the invention is defined by the appended claims.

### [THE TECHNICAL ISSUES TO BE SOLVED]

The development tendency of printed circuit boards is light, thin, short, small, sophisticated and higher frequency application in order to avoid data loss and interference during transmission process. The used resin must not only possess excellent electrical characteristics, but also the new developed low dielectric resin varnish composition needs to be operated under the existing conditions of operation processes and equipments to meet the environment requirements, this technique has become the important issue which the industry must overcome.

### [THE TECHNICAL MEANS TO SOLVE ISSUES]

In view of the above-mentioned issues, the present inventor, after many years of research and testing, found a resin with a saturated cyclic structure, i.e. having a saturated ring skeleton in its chemical structure, which can effectively reduce the substrate's thermal expansion coefficient, dielectric constant and dissipation factor. When the resin is used in a resin varnish formulation, it may get excellent electrical characteristics such as low dielectric constant Dk and low dissipation factor Df. The resin also can be matched with various types of curing agents to be processed in the existing equipments to meet the different needs of the substrate.

In accordance with this invention, the main purpose is to provide a circuit substrate with low dielectric constant, low dissipation factor, low moisture absorption and high thermal stability. A cheap naphtha cracking by-product - "dicyclopentadiene" (abbreviated as DCPD) is used in the substrate as a raw material, the raw material itself having a rigid aliphatic cyclic three-dimensional structure skeleton is reacted with a phenolic compound to synthesize a phenolic resin (dicyclopentadiene-phenolic Novolac, DCPD-PN) containing a DCPD structure, and then this DCPD resin is reacted with dihydrobenzoxazine (BX) or with epoxy resin to obtain dicyclopentadiene-dihydrobenzoxazine resin (DCPD-BX) or a DCPD-containing epoxy resin (Phenol Novolac Epoxy, DCPD-PNE), respectively. The resulting resin can be used to prepare a low dielectric, thermally stable circuit board having low moisture absorption, and copper clad laminates can be very easily processed and manufactured with current equipments and processing conditions.

The above-mentioned low dielectric resin varnish composition including (A) DCPD-containing phenolic resin, (B) one or more of the above epoxy resins or one of the epoxy resin with DCPD (DCPD-PNE), (C) DCPD-containing DCPD-BX resin, and (D) flame retardant agent, curing agent and accelerating agent is obtained by mixing evenly (A), (B), (C) or (B) + (C) and (D) in a certain percentage of solvent. Thus, resin varnish formulations for laminates according to the present invention are obtained, comprising:
A Main agent: The DCPD-PN raw material reacts with Epichlorohydrin (ECH) at a fixed equivalent ratio in the presence of NaOH to synthesize DCPD-epoxy resin (DCPD-PNE). Another BX resin is made from reacting DCPD-PN as a raw material with paraformaldhyde and aniline at a fixed equivalent ratio.
A Curing agent: It is predominantly Nan Ya's NPEH-710S or 710H. In order to increase DCPD content, DCPD-PN can also be used as a curing agent.
A Flame retardant agent: At present, three types of commonly used flame retardant agents are (I) traditional brominated flame retardants, such as tetrabromobisphenol (TBBA); (II) phosphorus flame retardants, such as a phosphate compound (DOPO); (III) additive type inorganic flame retardants, such as Al₂O₃, ATH, or any flame retardant agent may not be incorporated.

The resin composition for laminates according to the present invention is prepared via the following steps:
1. Firstly, the naphtha cracker product dicyclopentadiene having a rigid three-dimensional cyclic aliphatic skeleton is reacted with a phenolic compound to give (A) dicyclopentadiene phenolic resin (DCPD-PN);
2. then, said DCPD-PN comprising a DCPD component is reacted with epichlorohydrin (ECH) to form dicyclopentadiene phenolic epoxy resin (DCPD-PNE, also called Resin 1); or
3. DCPD-PN is reacted with a primary amine compound having both mono-functional and bi-functional groups, a formaldehyde or paraformaldehyde compound (i.e. polyformaldehyde, or polyoxymethylene) to obtain dicyclopentadiene - dihydrobenzoxazine (DCPD-BX) resin (Resin 2).

The resin composition for laminates according to the present invention possesses a saturated multi-ring structure, thus features better chemical and physical properties than conventional epoxy resins. When the fiberglass cloth is impregnated into the resin varnish formulation and then hot-press hardened, a circuit board with superior electrical properties, high thermal stability and low moisture absorption is obtained, applicable to general circuit boards, or high-frequency, high-function laminated circuit boards.

### [THE DETAILED DESCRIPTION OF THE INVENTION]

The invention relates to a low dielectric resin varnish composition for laminates, wherein the resin composition includes (A) dicyclopentadiene - phenolic resin (DCPD-PN), or (B) one or a variety of epoxy resins (DCPD-PNE), or (C) a new type of dicyclopentadiene - dihydrobenzoxazine (DCPD-BX) resin, or (B) + (C) resins and (D) flame retardant agent and curing accelerator.

Among them, a DCPD-containing (A) dicyclopentadiene - phenolic resin (DCPD-PN) is prepared by reacting (a) dicyclopentadiene with (b) a phenolic compound. Its structural formula is shown as the following formula (I): 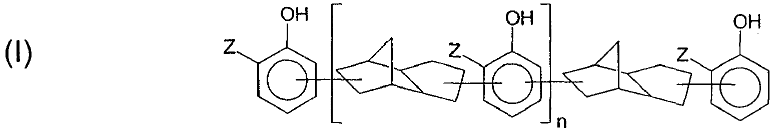 wherein
Z is -CH₃, -C₂H₅, -C(CH₃)₃, -H; and
n is 0.5~1.5.
Through a modification or a change reaction, a variety of patterns can be synthesized. Their synthesis is described in detail as follows :

### PREPARATION OF DCPD-PN

In a 5L four-neck glass reaction vessel with heating jackets, temperature control devices, an electric mixer, and condensing tubes, 940 grams of a phenolic compound and 2wt% (based on the weight of the phenolic compound) of Lewis acid catalyst (AlCl₃) are added. The mixture isheated to 110 °C while stirring, and reacted to 120 °C, 132 grams of DCPD are dropped into the reaction mixture to react for 4 hours at this constant temperature, then the resulting reaction solution is neutralized with sodium hydroxide and extracted with clean water to remove salts and the catalyst. Finally, the excess reactants are removed at 180°C and 70 torrs to obtain the product DCPD-PN.

In the above preparation of DCPD-PN, (a) dicyclopentadiene is a naphtha cracking by-product, (b) phenolic compounds are generally phenol, o-cresol, bisphenol (Bisphenol-A), 4,4'-bisphenol methane (Bisphenol-F), 4,4'-bisphenol sulfone (Bisphenol-S) or phenolic formaldehyde resin, preferably bisphenol or phenol-formaldehyde resin.

The solvent used in DCPD-PN preparation is of no particular restriction as long as the reactants can be dissolved. Most preferably a hydrocarbon solvent, such as toluene, xylene, etc. is used.

In accordance with the present invention, DCPD-PN can be added as a curing agent to raise the content of DCPD. the phenolic resin curing agents can also be used, such as polyvalent amines, polyvalent carboxylic acids, dicyanodiamide, anhydrides, phenol-formaldehyde resin (Phenol Novolac, referred to as PN), o-cresol-formaldehyde resin (Cresol Novolac, referred to as CN), melamine phenol formaldehyde resin (Melamine Phenol Novolac, referred to as MPN), bisphenol formaldehyde resin (BPA Phenol Novolac, referred to as BPA-PN), tetraphenol ethane resin (Tetra-Phenol Novolac, referred to as TPN), etc.

The component (B) in the resin varnish composition is one or more of epoxy resins, in which dicyclopentadiene epoxy resin (DCPD-PNE), also abbreviated as Resin 1, is an epoxy resin produced from reacting DCPD-PN with epichlorohydrine. Its structural formula is shown as following formula (II): 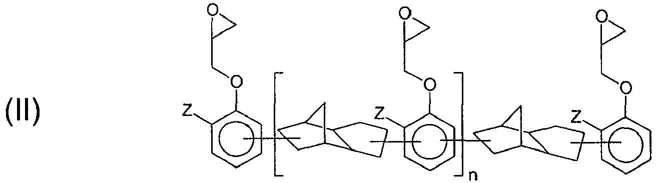 wherein
Z is -CH₃ -C₂H₅, -C(CH₃)₃, -H; and
n is 0.5~1.5.

### PREPARATION OF DCPD-PNE (RESIN 1)

In a 5L four-neck glass reaction vessel with heating jackets, temperature control devices, an electric mixer, and condensing tubes, 500 grams of DCPD-PN and 2927.2 grams of epichlorohydrin are added, warmed to 55°C for pre-dissolving, and 281 g of sodium hydroxide are dropped therein for 4 - 6 hours. The resulting mixture is then heated to 78 °C, and reacted at 110 Torrs pressure for 1 hour. Finally, the excess reactants are removed at 180°C and 70 torrs to obtain the product DCPD-PNE.

The so-called epoxy resin can also include bisphenol (BPA) type epoxy resin, brominated BPA type epoxy resin, phenolic type epoxy resin and phosphate type epoxy resin.

(C) dicyclopentadiene - dihydrobenzoxazine resin (DCPD-BX) comprising DCPD, also called Resin 2, is obtained by reacting the following 3 compounds: (1) dicyclopentadiene - phenolic resin (DCPD-PN), i.e. the above component A; (2) a primary amine compound with mixed mono-functional group and bi-functional groups; (3) formaldehyde or paraformaldehyde. Its structural formula is shown as following formula (III): 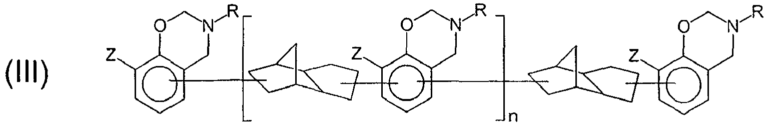
Z is -CH₃, -C₂H₅, -C(CH₃)₃, -H;
n is 0~1; and
R is alkyl or aryl.
A variety of types can be gained through modification. Their synthesis will be described in detail as follows:

### PREPARATION OF DCPD-BX (RESIN 2)

In a 5L four-neck glass reaction vessel with heating jackets, temperature control devices, an electric mixer, and condensing tubes, 480 grams of DCPD-PN and 486 grams of paraformaldehyde are dissolved in 500 grams of toluene while stirring, and 279 grams of aniline are slowly trickled down into the resulted solution, with temperature controlled between 60 - 110 °C to react for 4 to 6 hours.The removal of solvent and unreacted materials is conducted at 180°C and 70 torrs to obtain solid dicyclopentadiene - dihydrobenzoxazine resin.

The raw material (1) for the preparation of DCPD-BX Resin 2 is (A) dicyclopentadiene phenolic resin (DCPD-PN) comprising DCPD component.

The raw material (2) for the preparation of DCPD-BX Resin 2 is a primary amine compound with mixed mono-functional and bi-functional groups, which generally includes methyl amine, ethyl amine, aniline, o-toluidine, o-methoxy aniline (i.e. anisidine), but can also include aliphatic or aromatic amine compounds. Most preferably it is aniline or 2-amino diphenyl methane.

The raw material (3) for the preparation of DCPD-BX Resin 2 is formaldehyde or paraformaldhyde. Generally, formaldehyde, paraformaldehyde or formaldehyde vapor are used, while paraformaldehyde is the best.

The solvent used in the preparation of DCPD-BX Resin 2 is of no particular restriction as long as the reactants can be dissolved therein. Hydrocarbon solvents such as toluene, xylene are the best.

The component (D) used in the resin varnish composition according to the present invention includes flame retardant agents and curing accelerators. Brominated flame retardant agents are mainly brominated and phosphorated resins: Inorganic filler flame retardants may also be used. Brominated flame retardant agents are: tetrabromobisphenol (TBBA), NPEB-485A80 (trade name, produced by Nan Ya Plastics Corporation, bromine content of 18 ~ 21 %), NPEB-454A80 (trade names, produced by Nan Ya Plastics Corporation, bromine content of 18 - 21%). Phosphorus flame retardants are DOPO (9,10-dihydro-9-oxa-10-phosphaphenanthrene-10-oxide), DOPO-Hydroquinone (DOPO-HQ), DOPO-Phenol Novolac Epoxy Resin (DOPO-PNE), DOPO-Hydroquinone-Phenol Novolac Epoxy Resin (DOPO-HQ-PNE). The inorganic filler flame retardants are mainly aluminum hydroxide, silica, barium sulfate, alumina, boron nitride and so on.

The curing accelerators also used the present invention are tertiary phosphine, tertiary amine, quaternary phosphonium salt, quaternary ammonium salt and imidazole compounds, wherein tertiary phosphines include triphenylphosphine, etc.; tertiary amines include 3-methyl aniline, triethyl amine, tributyl amine, dimethyl ethanol amine, etc.; quaternary phosphonium salts include tetrabutyl phosphonium bromide, tetraphenyl phosphonium bromide, ethyl triphenyl phosphonium bromide, propyl triphenyl phosphonium chloride, butyl triphenyl phosphonium bromide and other halide-containing quaternary phosphonium salts; quaternary ammonium salts include tetramethyl ammonium bromide, tetraethyl ammonium bromide, tetrabutyl ammonium bromide, tri-phenylmethyl ammonium bromide, tri-phenyl ethyl ammonium bromide and other halide-containing containing quaternary ammonium salts; imidazole compounds include 2 - methyl-imidazole, 2 - ethyl-imidazole, 2 - dodecyl-imidazole, 2 - phenyl-imidazole, 4 - methyl-imidazole, 4 - ethyl-imidazole, 4 - dodecyl- imidazole, 2 - ethyl - 4 - methylimidazole, 2 - ethyl - 4 - hydroxymethyl-imidazole, etc., and most suitably 2 - methyl-imidazole or 2 - ethyl -4 - methyl-imidazole. The above-mentioned curing accelerator can be used alone or in a mixture of two or more species, its dose is 0.01 - 1 PHR (Parts per Hundreds of resin), and most suitably 0.04 - 0.15 PHR based on the total resin amount.

The low dielectric resin composition according to the present invention is made from the synthetic resin with a cyclic structure according to the present invention, wherein (A) DCPD-PN content represents 0 ~ 50 wt% of total resin; (B) DCPD-PNE (Resin 1) accounts for 13 ~ 60 wt% of the total resin; (C) DCPD-BX (Resin 2) accounts for 30 - 50 wt% of total resin, and; (D) flame retardant agents accounts for 22 - 32 wt% of the total resin; curing accelerator represents 0.01 - 1 PHR of the total resin. Solvents are added to adjust the varnish viscosity. They can be organic aromatic solvents, protic solvents, ketone solvents, ether solvents and ester solvents (appropriate solvents are toluene, N, N-dimethyl formamide, acetone, methyl ethyl ketone, 1 - methoxy -2 - propanol, ethyl acetate and so on.) The above-mentioned Resin 1 and Resin 2 may be used alone or together or blended with other epoxy resins.

In the manufacture of printed circuit board laminates, the glass fiber cloth is impregnated with the above-mentioned formulation composition, and then heated, so that the impregnated glass fiber cloth is dried into a prepreg, and copper foil can be put on one side or both sides of the prepreg, thereby one or more of the resulted prepregs can be brought together to form a laminate, which is heated and pressurized to obtain a copper clad laminate (CCL). The curing temperature range of this resin varnish composition ranges from 30 to 300°C, preferably from 150 to 210°C.

### [EXAMPLES]

The present invention will be described in detail below with reference to numerous examples, the various code numbers and the ingredients used in examples and comparative examples are as follows:
Resin 1: The Inventive component (B) DCPD-PNE resin: its epoxy equivalent ranging from 270 to 230g/eq.
Resin 2: The Inventive component (C) DCPD-BX resin: its nitrogen content 6.2 wt%.
Resin.3: The brominated resin produced by Nan Ya Plastics Corporation, trade name NPEB-485A80.
Resin 4: Nan Ya Plastics Corporation's phosphorated resin (DOPO-638), trade name 210A70.
Resin 5: Nan Ya Plastics Corporation 's phosphorated resin (DOPO-HQ-638), trade name 220A70.

Curing agent 1: Nan Ya Plastics Corporation's phenolic resin, trade name 710HA65
Curing agent 2: Nan Ya Plastics Corporation's phenolic resin, trade name 710SA65.
Curing agent 3: The Inventive DCPD-PN.

Flame retardant agent 1: brominated flame agent, tetrabromo bisphenol (TBBA).
Flame retardant agent 2: Japan DaiHachi Chemical Company's phosphorus-containing flame agent, trade name PX-200.
Flame retardant agent 3: aluminum hydroxide (ATH) filler.
Flame retardant agent 4: silicon dioxide (SiO2) filler.

Curing accelerator 2MI: 2 -methylimidazole, 14.2wt% dissolved in DMF.
Glass Fiber Cloth 7628: Nan Ya Plastics Corporation's glass fiber cloth.

### [Example 1]

DCPD-PNE is used as a base resin and matched with curing agent 710HA65; TBBA is used as a flame retardant agent with their formulations detailed in Table 1, then the solvent acetone is added to adjust the solid content of the resulted resin varnish composition to be 65%, the 7628 glass fiber cloth is impregnated in the above varnish resin solution, and then a prepreg obtained is taken out from the impregnating machine at a temperature of 170°C, dried for a few minutes and while adjusting drying time, so that after drying, the melt viscosity of the prepreg is controlled between 4,000 - 10,000poise, and finally eight film layers are stacked between two 35-um-thick copper foils, under a pressure of 25kg/cm². The temperature is controlled as follows:
85°C → 85°C → 200°C → 200°C → 130°C
20min 30min 120min cooling slowly
After hot-pressing, a 1.6mm-thick copper clad laminate is obtained. The performance of the composition is detailed in Table 1

### [Example 2]

Following the same steps as Example 1, except that the curing agent is changed to be 710SA65, the performance of the resulted composition is detailed in Table 1.

### [Example 3]

Repeating Example 1, except that the curing agent is changed to be DCPD-PN, the performance of the resulted composition is detailed in Table 1.

### [Example 4]

DCPD-PNE is used as the base resin and matched with curing agent 710HA65, the flame retardant agent is changed to be PX-200 phosphorus flame retardant agent, the formulation compositions are detailed in Table 1. Repeating the manufacturing steps of the copper clad laminate of Example 1, the features of the resulted composition are set set in Table 1.

### [Example 5]

Repeating Example 4, except that the curing agent is changed into 710SA65, the performance of the resulted composition is detailed in Table 1.

### [Example 6]

Repeating Example 4, except that the curing agent is substituted by DCPD-PN, the performance of the resulted composition is detailed in Table 1.

### [Example 7]

DCPD-BX is used as the base resin and DCPD-PNE resin is added to adjust the equivalent, matched with curing agent 710HA65, and aluminum hydroxide and silica are used as flame retardant agents, the formulation composition is detailed in Table 1, then repeating the manufacturing steps of the copper clad laminate of Example 1, the performance of the composition obtained is detailed in Table 1.

### [Example 8]

Repeating Example 7, except that the curing agent is changed into 710SA65, the performance of the resulted composition is detailed in Table 1.

### [Example 9]

Repeating Example 7, except that the curing agent is substituted by DCPD-PN, the performance of the resulted composition is detailed in Table 1.

### [Example 10]

DCPD-BX is used as the base resin, matched with the phosphorated resin 210A70 and curing agent 710HA65 to get a halogen-free substrate, the formulation composition is detailed in Table 2, and in analogy to the manufacturing steps of the copper clad laminate of Example 1, the performance of the composition obtained is detailed in Table 2..

### [Example 11]

Repeating Example 10, except that the curing agent is changed into 710SA65, the performance of the resulted composition is detailed in Table 1.

### [Example 12]

Repeating Example 10, except that the curing agent is changed into DCPD-PN, the performance of the resulted composition is detailed in Table 1.

### [Example 13]

DCPD-BX is used as the base resin matched with the phosphorated resin 210A70 and curing agent 710HA65 to get a halogen-free substrate, the formulation composition is detailed in Table 2, and in analogy to the manufacturing steps of the copper clad laminate of Example 1, the performance of the composition obtained is detailed in Table 2.

### [Example 14]

Repeating Example 13, except that the curing agent is changed into 710SA65, the performance of the resulted composition is detailed in Table 1.

### [Example 15]

Repeating Example 13, except that the curing agent is changed into DCPD-PN, the performance of the resulted composition is detailed in Table 1.

### [Comparative Example 1]

The brominated epoxy resin (Nan Ya's brominated epoxy resin, trade name NPEB-485A80) is used as the based resin and matched with curing agent 710HA65, the formulation composition is detailed in Table 2, and in analogy to the manufacturing steps of the copper clad laminate of Example 1, the performance of the composition obtained is detailed in Table 2.

### [Comparative Example 2]

Repeating Comparative Example 1, except that the curing agent is changed into 710SA65, the performance of the resulted composition is detailed in Table 1.

### [Comparative Example 3]

Repeating Comparative Example 1, except that the curing agent is changed into DCPD-PN, the performance of the resulted composition is detailed in Table 1.

### [Measurement Note]

1. Varnish Gelling Time (sec):
   0.3ml of resin varnish is put on the heating plate at 170°C, the gelling time thereof is measured.
2. Glass Transition Temperature (°C):
   Glass transition temperature is measured with a differential scanning calorimeter (DSC) at the heating rate = 20 °C / min.
3. Fire Resistance :
   Samples are cut into specimens with a rectangle shape of 0.5 in × 4.7 in. A burner flame is applied to the free end of the specimen for two 10 second intervals separated by the time it takes for flaming combustion to cease after the first application. The durations of flaming combustion after the each burner flame application are recorded.
   4. Water Absorptivity (%):
      Specimens are heated in a pressure cooker at 120 °C and 2 atm pressure.
   5. Dissipation Factor (1 GHz):
      Test samples are cut into specimen pieces with a square shape of 5 cm × 5 cm in which 3 points are taken to measure the plate thicknesses, then the specimen is clamped in a folder and put into the analytical instrument for the dielectric measurements, finally the average values are calculated.
   6. Dielectric Constant (1 GHz):
      The etched substrate is cut to a 5 cm² square specimen, baked in the oven at 105°C for 2 hours, then it is taken out for the thickness measurement at 3 points of the specimen with a plate thickness gauge, then the specimen is clamped in a folder and put into the dielectric instrument for measurements, the average value of 3 points data is calculated.

**Table 1 : Table 1: Resin Varnish Formulation Composition and performance**

| | Example 1 | Example 2 | Example 3 | Example 4 | Example 5 | Example 6 | Example 7 | Example 8 | Example 9 |
|---|---|---|---|---|---|---|---|---|---|
| Resin 1 DCPD-PNE | **60** | **60** | **52** | **51** | **51** | **43** | **13** | **13** | **13** |
| Resin 2 DCPD-BX | | | | | | | **52** | **52** | **50** |
| Resin 3 NPEB-485A80 | | | | | | | | | |
| Resin 4 210A70 | | | | | | | | | |
| Resin 5 220A70 | | | | | | | | | |
| Curing agent 1 710HA70 | 15 | | | 21 | | | 3 | | |
| Curing agent 2 710SA70 | | 15 | | | 21 | | | 3 | |
| Curing agent 3 DCPD-PN | | | 25.7 | | | 34 | | | 6 |
| Flame Retardant Agent 1 TBBA | 25 | 25 | 22.3 | | | | | | |
| Flame Retardant Agent 2 PX-200 | | | | 28 | 28 | 23 | | | |
| Flame Retardant Agent 3 ATH | | | | | | | 16 | 16 | 15.5 |
| Flame Retardant Agent 4 Si02 | | | | | | | 16 | 16 | 15.5 |
| Accelerator 2MI(PHR) | 0.3 | 0.25 | 0.31 | 0.28 | 0.24 | 0.28 | 0.5 | 0.5 | 0.5 |
| Varnish Gelling Time, sec | 380 | 364 | 372 | 375 | 370 | 368 | 365 | 355 | 361 |
| Glass Transition Temperature °C | 159 | 172 | 164 | 157 | 171 | 165.5 | 163.5 | 173.5 | 167.2 |
| Fire Resistance | 94V-0 | 94V-0 | 94V-1 | 94V-0 | 94V-0 | 94V-1 | 94V-0 | 94V-0 | 94V-0 |
| Water Absorptivity % | 0.08 | 0.07 | 0.07 | 0.08 | 0.07 | 0.08 | 0.09 | 0.07 | 0.08 |
| Dielectric Constant (1GHz) | 4.22 | 4.2 | 4.18 | 4.2 | 4.21 | 4.18 | 3.9 | 3.89 | 3.92 |
| Dissipation Factor(1GHz) | 0.014 | 0.012 | 0.012 | 0.014 | 0.016 | 0.012 | 0.008 | 0.009 | 0.009 |

**Table 2 : Resin Varnish Formulation Composition and performance**

| | Example 10 | Example 11 | Example 12 | Example 13 | Example 14 | Example 15 | Comparative Example 1 | Comparative Example 2 | Comparative Example 3 |
|---|---|---|---|---|---|---|---|---|---|
| Resin 1 DCPD-PNE | | | | | | | | | |
| Resin 2 DCPD-BX | 52 | 52 | 50 | 52 | 52 | 50 | | | |
| Resin 3 NPEB-485A80 | | | | | | | 78 | 78 | 68 |
| Resin 4 210A70 | 13 | 13 | 13 | | | | | | |
| Resin 5 220A70 | | | | 13 | 13 | 13 | | | |
| Curing agent 1 710HA70 | 3 | | | 3 | | | 22 | | |
| Curing agent 2 710SA70 | | 3 | | | 3 | | | 22 | |
| Curing agent 3 DCPD-PN | | | 6 | | | 6 | | | 32 |
| Flame Retardant Agent 1 TBBA | | | | | | | | | |
| Flame Retardant Agent 2 PX-200 | | | | | | | | | |
| Flame Retardant Agent 3 ATH | 16 | 16 | 15.5 | 16 | 16 | 15.5 | | | |
| Flame Retardant Agent 4 SiO₂ | 16 | 16 | 15.5 | 16 | 16 | 15.5 | | | |
| Accelerator 2MI(PHR) | 0.25 | 0.21 | 0.26 | 0.28 | 0.24 | 0.28 | 0.1 | 0.1 | 0.1 |
| Varnish Gelling Time sec | 360 | 355 | 345 | 335 | 345 | 350 | 320 | 318 | 324 |
| Glass Transition Temperature °C | 158 | 173 | 160 | 162 | 175 | 168 | 153 | 167 | 162 |
| Fire Resistance | 94V-0 | 94V-0 | 94V-1 | 94V-0 | 94V-0 | 94V-1 | 94V-0 | 94V-0 | 94V-0 |
| Water Absorptivity % | 0.08 | 0.07 | 0.07 | 0.08 | 0.07 | 0.08 | 0.07 | 0.08 | 0.08 |
| Dielectric Constant (1GHz) | 4.32 | 4.18 | 4.16 | 4.35 | 4.2 | 4.15 | 4.7 | 4.6 | 4.4 |
| Dissipation Factor (1GHz) | 0.014 | 0.013 | 0.012 | 0.015 | 0.014 | 0.012 | 0.03 | 0.028 | 0.025 |

### [Efficacy of Invention]

The copper clad laminates made from the formulations containing DCPD-PNE in Example 1~6 exhibit the characteristics of dielectric constant 4.18 - 4.21 and dissipation factor 0.012 - 0.016. Those made from of the formulations containing DCPD-BX in Example 10~15 offer the properties of dielectric constant 4.15 ~ 4.32 and dissipation factor 0.012 - 0.016. In the formulations of Example 7 ~ 9, both of DCPD-PNE and DCPD-BX are used. The resulting laminates show the characteristics of low dielectric constant 3.89 - 3.92 and dissipation factor 0.008 - 0.009. Significantly better than the laminates produced from the other formulations without the resin having DCPD structure, the latter have the properties of dielectric constant 4.4 - 4.7 and dissipation factor 0.025 - 0.03.

As revealed in Examples Table 1 and Table 2, the fiberglass cloth impregnated with the DCPD containing lacquer resin after curing does have low moisture absorptivity, low dielectric constant and low dissipation factor. The copper clad laminates made from the pressure lamination of the resin containing DCPD-PN as a curing agent can effectively reduce the dielectric constant and dissipation factor. Furthermore, if DCPD-BX resin is added, since the content of the resin with DCPD structure increases, and the flame retardant fillers are present in the resin varnish composition, the dielectric constant can be further reduced, and UL94V-0 flammability standards can also be met and a good thermal stability is achieved.

## Claims

1. A low dielectric resin varnish composition for laminates comprising:
(a) 30 to 50 % based on the total resin weight of a dicyclopentadiene-dihydrobenzoxazine (DCPD-BX) resin; or a hybrid resin of 13 to 60 % , based on the total resin weight, of one or more dicyclopentadiene phenolic epoxy resins (DCPD-PNE) and 30 to 50 % based on the total resin weight of a dicyclopentadiene-dihydrobenzoxazine (DCPD-BX) resin;
(b) flame retardant agent,
(c) curing agent or curing accelerator; and
(d) solvent,
wherein the dicyclopentadiene-dihydrobenzoxazine resin (DCPD-BX) is prepared by mixing and stirring to react
(1) dicyclopentadiene - phenolic resin (DCPD_PN) of the formula 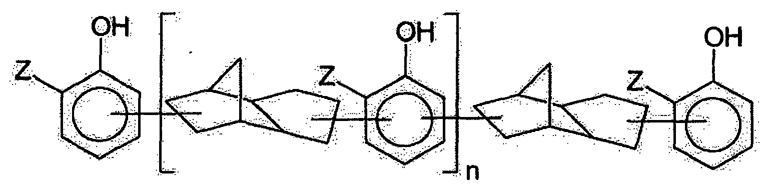 wherein
Z is -CH₃, -C₂H₅, -C(CH₃)₃or, -H; and
n is 0.5-1.5;
(2) a primary amine compound with mixed mono-functional and bi-functional groups; and
(3) a formaldehyde or paraformaldehyde compound;
wherein the dicyclopentadiene-dihydrobenzoxazine resin (DCPD-BX) has the structural formula: 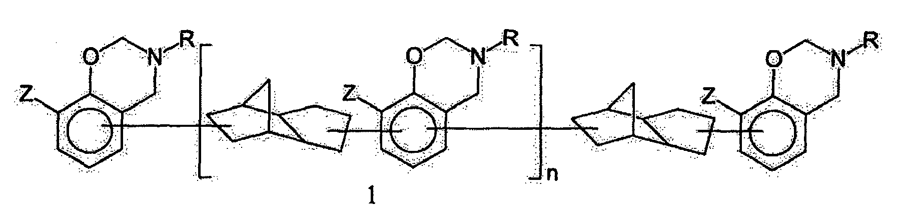 wherein
Z is -CH₃, -C₂H₅, -C(CH₃)₃or, -H;
R is alkyl or aryl; and
n is 0-1; and
wherein said dicyclopentadiene phenolic epoxy resins (DCPD-PNE) are prepared by reacting
(1) a dicyclopentadiene phenolic resin (DCPD-PN) of the formula 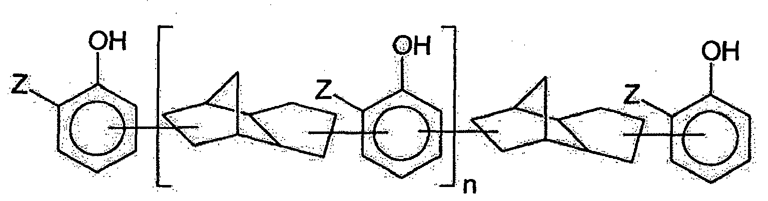 wherein
Z is -CH₃, -C₂H₅, -C(CH₃)₃or, -H; and
n is 0.5-1.5;
with
(2) epichlorohydrin;
wherein the dicyclopentadiene phenolic epoxy resins (DCPD-PNE) have the structural formula: 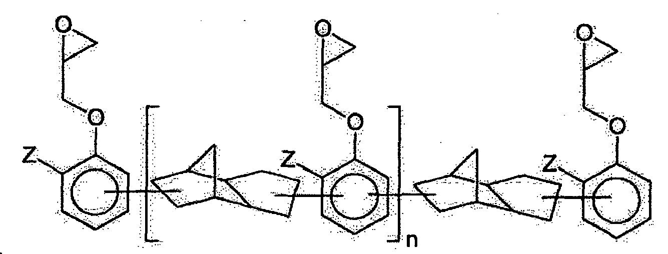 wherein
Z is -CH₃, -C₂H₅, -C(CH₃)₃, or -H; and
n is 0-2.

2. The low dielectric resin varnish composition for laminates as claimed in Claim 1, wherein dicyclopentadiene used to produce the dicyclopentadiene-phenolic resin (DCPD-PN) is a naphtha cracking by-product; and the phenolic compounds are selected from phenol, o-cresol, bisphenol (Bisphenol-A), 4,4'-diphenyl methane (Bisphenol-F), 4,4'-diphenyl sulfone (Bisphenol-S) or phenolic resin.

3. The low dielectric resin varnish composition for laminates as claimed in Claim 1, wherein the curing agent is a dicyclopentadiene-phenolic resin (DCPD-PN).

4. The low dielectric resin varnish composition for laminates as claimed in Claim 1, wherein the resin curing agent can be selected from phenolic resin, amines, organic acids and acid anhydride type curing agents.

5. The low dielectric resin varnish composition for laminates as claimed in Claim 4, wherein the resin curing agent is selected from the group consisting of polyvalent amines, polyvalent carboxylic acid, dicyanodiamide, anhydride, phenol-formaldehyde resin (Phenol Novolac, referred to as PN), o-cresol-formaldehyde resin (Cresol Novolac, referred to as CN), melamine-phenol formaldehyde resin (Melamine Phenol Novolac, MPN), bisphenol formaldehyde resin (BPA Phenol Novolac, BPA-PN), tetraphenol ethane resin (TetraPhenol Novolac, TPN) and dicyclopentadiene -- phenolic resin (Dicyclopentadiene-Phenolic Novolac, DCPD-PN).

6. The low dielectric resin varnish composition for laminates as claimed in Claim 1, wherein the composition comprises the dicyclopentadiene dihydrobenzoxazine resin (DCPD-BX) or the hybrid resin of one or more dicyclopentadiene phenolic epoxy resins (DCPD-PNE) and a dicyclopentadiene-dihydrobenzoxazine (DCPD-BX) resin alone or in a mixture with other epoxy resins.

7. The low dielectric resin varnish composition for laminates as claimed in Claim 6, wherein the primary amine compound with mixed mono-functional and bi-functional groups used in the production of dicyclopentadiene-dihydrobenzoxazine resin (DCPD-BX) is an aliphatic or aromatic amine compound.

8. The low dielectric resin varnish composition for laminates as claimed in Claim 7, wherein the primary amine compound is a primary amine such as methyl amine, aniline, o-toluidine or anisidine.

9. The low dielectric resin varnish composition for laminates as claimed in Claim 6, wherein the formaldehyde or paraformaldehyde compound used for the preparation of dicyclopentadiene-dihydrobenzoxazine resin (DCPD-BX) is selected from formaldehyde, paraformaldehyde, or formaldehyde vapor.

10. The low dielectric resin varnish composition for laminates as claimed in Claim 6, wherein other epoxy resins comprise a brominated epoxy resin or phosphorated epoxy resin.

11. The low dielectric resin varnish composition for laminates as claimed in Claim 1, wherein the flame retardant agent is a brominated or phosphorated resin, or an inorganic filler flame retardant agent.

12. The low dielectric resin varnish composition for laminates as claimed in Claim 11, wherein
(1) the brominated flame retardant agent is a tetrabromo bisphenol (TBBA) or tetrabromo bisphenol type epoxy resin, or
(2) the phosphorated flame retardant agents are 9,10-dihydro-9-oxa-10-phosphaphenanthrene-10-oxide (DOPO), DOPO-Hydroquinone (DOPO-HQ) and its phenolic epoxy resin, or
(3) the inorganic filler flame retardant agents are selected from aluminum hydroxide, silica, barium sulfate, aluminum oxide and boron nitride.

13. The low dielectric resin varnish composition for laminates as claimed in Claim 1, wherein the curing accelerator is one compound or a mixture of two or more compounds and accounts for 0.04-0.15 parts per hundred of resin of the total resin.

14. The low dielectric resin varnish composition for laminates as claimed in Claim 1, wherein the curing accelerator is selected from imidazole compounds.

15. The low dielectric resin varnish composition for laminates as claimed in Claim 1, wherein the curing accelerator is selected from 2-methyl-imidazole (2MI) and 2-ethyl-4 methylimidazole (2E4MZ).

## Patentansprüche

1. Eine schwach dielektrische Harzlack-Zusammensetzung für Schichtverbundwerkstoffe umfassend:
a) 30 bis 50 Gew.-% basierend auf dem Gesamtgewicht des Harzes eines Dicyclopentadien-Dihydroxybenzoxazin-Harzes (DCPD-BX); oder eines Hybrid-Harzes aus 13 bis 60 Gew.-% basierend auf dem Gesamtgewicht des Harzes eines oder mehrerer Dicyclopentadienepoxyphenol-Harze (DCPD-PNE), und 30 bis 50 Gew.-% basierend auf dem Gesamtgewicht des Harzes eines Dicyclopentadien-Dihydroxybenoxazin (DCPD-BX) -Harzes,
b) ein Flammschutzmittel;
c) ein Härtungsmittel oder einen Härtungsbeschleuniger; und
d) ein Lösungsmittel,
wobei das Dicyclopentadien-Dihydroxybenzoxazin-Harz (DCPD-BX) durch Mischen und Rühren hergestellt wird, um
(1) Dicyclopentadien-Phenol-Harz (DCPD-PN) der Formel 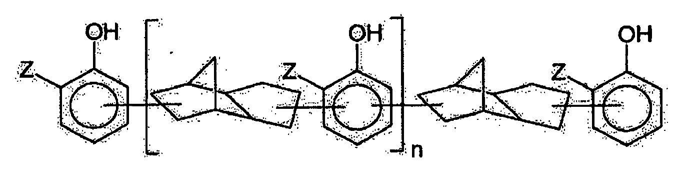 wobei
Z -CH₃, -C₂H₅, -C(CH₃)₃ oder -H ist, und
n 0,5-1,5 ist;
(2) eine primäre Amin-Verbindung mit gemischten mono-funktionellen und bi-funktionellen Gruppen; und
(3) eine Formaldehyd- oder Paraformaldehyd-Verbindung
miteinander umzusetzen,
wobei das Dicyclopentadien-Dihydroxybenzoxazin-Harz (DCPD-BX) folgende 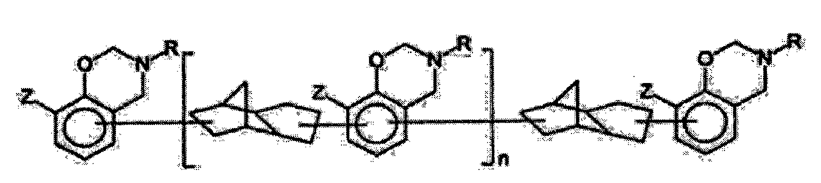 Strukturformel besitzt:
wobei
Z -CH₃, -C₂H₅, -C(CH₃)₃ oder -H ist;
R Alkyl oder Aryl ist; und
n 0-1 ist; und
wobei die Dicyclopentadienepoxyphenol-Harze (DCPD-PNE) durch Umsetzen von
(1) einem Dicyclopentadienphenol-Harz (DCPD-PN) der Formel 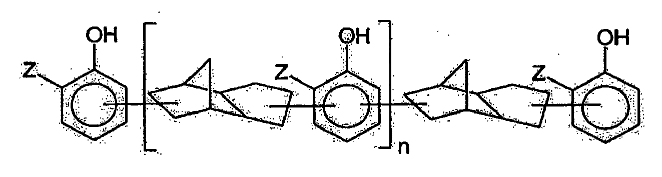 wobei
Z -CH₃, -C₂H₅, -C(CH₃)₃ oder -H ist; und
n 0,5-1,5 ist;
mit
(2) Epichlorhydrin hergestellt werden;
wobei die Dicyclopentadienepoxyphenol-Harze (DCPD-PNE) folgende Strukturformel besitzen: 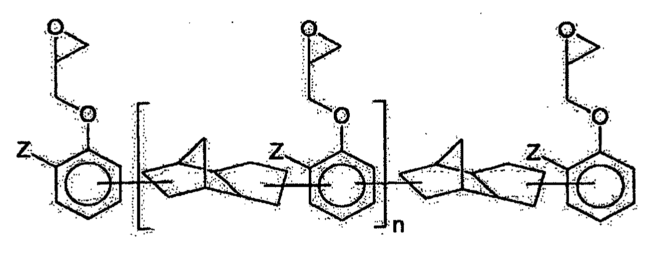 wobei
Z -CH₃, -C₂H₅, -C(CH₃)₃ oder -H ist; und
n 0-2 ist.

2. Die schwach dielektrische Harzlack-Zusammensetzung für Schichtverbundwerkstoffe gemäß Anspruch 1, wobei das Dicyclopentadien zur Herstellung des Dicyclopentadien-Phenol-Harzes (DCPD-PN) ein Nebenprodukt beim Naphtha-Cracking ist; und die phenolischen Verbindungen ausgewählt sind aus Phenol, o-Cresol, Bisphenol (Bisphenol-A), 4,4'-Diphenylmethan (Bisphenol-F), 4,4'-Diphenylsulfon (Bisphenol-S) oder Phenol-Harz.

3. Die schwach dielektrische Harzlack-Zusammensetzung für Schichtverbundwerkstoffe gemäß Anspruch 1, wobei das Härtungsmittel ein Dicyclopentadien-Phenol-Harz (DCPD-PN) ist.

4. Die schwach dielektrische Harzlack-Zusammensetzung für Schichtverbundwerkstoffe gemäß Anspruch 1, wobei das Harz-Härtungsmittel aus Phenol-Harz, Aminen, organischen Säuren und Härtungsmitteln des Säureanhydrid-Typs ausgewählt werden kann.

5. Die schwach dielektrische Harzlack-Zusammensetzung für Schichtverbundwerkstoffe gemäß Anspruch 4, wobei das Harz-Härtungsmittel ausgewählt ist aus der Gruppe bestehend aus polyvalenten Aminen, polyvalenten Carbonsäuren, Dicyandiamid, Anhydrid, Phenol-Formaldehyd-Harz (Phenol Novolak, als PN bezeichnet), o-Cresol-Formaldehyd-Harz (Cresol Novolak, als CN bezeichnet), Melamin-Phenolformaldehyd-Harz (Melamine Phenol Novolak, MPN), Bisphenolformaldehyd-Harz (BPA Phenol Novolak, BPA-PN), Tetraphenolethan-Harz (TetraPhenol Nocolak, TPN) und Dicyclopentadien-Phenol-Harz (Dicyclopentadien-Phenolides Novolak, DCPD-PN).

6. Die schwach dielektrische Harzlack-Zusammensetzung für Schichtverbundwerkstoffe gemäß Anspruch 1, wobei die Zusammensetzung das Dicyclopentadien-Dihydroxybenzoxazin-Harz (DCPD-BX) oder das Hybrid-Harz aus einem oder mehreren Diyoclopentadienepoxyphenol-Harzen (DCPD-PNE) und einem Dicyclopentadien-Dihydroxybenzoxazin-Harz (DCPD-BX) allein oder in einer Mischung mit anderen Epoxidharzen umfasst.

7. Die schwach dielektrische Harzlack-Zusammensetzung für Schichtverbundwerkstoffe gemäß Anspruch 6, wobei die primäre Amin-Verbindung mit gemischten monofunktionellen und bi-funktionellen Gruppen, die bei der Herstellung eines Dicyclopentadien-Dihydroxybenzoxazin-Harzes (DCPD-BX) verwendet wird, eine aliphatische oder aromatische Amin-Verbindung ist.

8. Die schwach dielektrische Harzlack-Zusammensetzung für Schichtverbundwerkstoffe gemäß Anspruch 7, wobei die primäre Amin-Verbindung ein primäres Amin wie Methylamin, Anilin, o-Toluidin oder Anisidin ist.

9. Die schwach dielektrische Harzlack-Zusammensetzung für Schichtverbundwerkstoffe gemäß Anspruch 6, wobei die Formaldehyd- oder Paraformaldehyd-Verbindung, die bei der Herstellung des Dicyclopentadien-Dihydroxybenzoxazin-Harzes (DCPD-BX) verwendet wird, ausgewählt ist aus Formaldehyd, Paraformaldehyd oder Formaldehyd-Dampf.

10. Die schwach dielektrische Harzlack-Zusammensetzung für Schichtverbundwerkstoffe gemäß Anspruch 6, wobei die anderen Epoxidharze ein bromiertes Epoxidharz oder phosphatiertes Epoxidharz umfassen.

11. Die schwach dielektrische Harzlack-Zusammensetzung für Schichtverbundwerkstoffe gemäß Anspruch 1, wobei das Flammschutzmittel ein bromiertes oder phosphatiertes Harz oder ein anorganisches Füllstoff-Flammschutzmittel ist.

12. Die schwach dielektrische Harzlack-Zusammensetzung für Schichtverbundwerkstoffe gemäß Anspruch 11, wobei
(1) das bromierte Flammschutzmittel ein Tetrabromobisphenol (TBBA) oder Epoxidharz des Tetrabromobisphenol-Typs ist, oder
(2) die phosphatierten Flammschutzmittel 9,10-Dihydro-9-oxa-10-phosphaphenanthren-10-oxid (DOPO), DOPO-Hydrochinon (DOPO-HQ) und sein phenolisches Epoxidharz sind, oder
(3) die anorganischen Füllstoff-Flammschutzmittel ausgewählt sind aus Aluminiumhydroxid, Silica, Bariumsulfat, Aluminiumoxid und Bornitrid.

13. Die schwach dielektrische Harzlack-Zusammensetzung für Schichtverbundwerkstoffe gemäß Anspruch 1, wobei der Härtungsbeschleuniger eine Verbindung oder eine Mischung zweier oder mehrerer Verbindungen ist und 0,04-0,15 Teile pro hundert Teile Harz (phr) des gesamten Harzes ausmacht.

14. Die schwach dielektrische Harzlack-Zusammensetzung für Schichtverbundwerkstoffe gemäß Anspruch 1, wobei der Härtungsbeschleuniger ausgewählt ist aus Imidazol-Verbindungen.

15. Die schwach dielektrische Harzlack-Zusammensetzung für Schichtverbundwerkstoffe gemäß Anspruch 1, wobei der Härtungsbeschleuniger ausgewählt ist aus 2-Methylimidazol (2MI) und 2-Ethyl-4-methylimidazol (2E4MZ).

## Revendications

1. Composition de vernis de résine à faible constante diélectrique pour stratifiés comprenant :
(a) de 30 à 50 % sur la base du poids total de résine d'une résine de dicyclopentadiène-dihydrobenzoxazine (DCPD-BX) ; ou une résine hybride de 13 à 60 %, sur la base du poids total de résine, d'une ou plusieurs résines époxy dicyclopentadiène-phénoliques (DCPD- PNE) et de 30 à 50 % sur la base du poids total de résine d'une résine dicyclopentadiène-dihydrobenzoxazine (DCPD-BX) ;
(b) un agent ignifugeant,
(c) un agent de durcissement ou un accélérateur de durcissement ; et
(d) un solvant,
dans lequel la résine de dicyclopentadiène-dihydrobenzoxazine (DCPD-BX) est préparée par mélange et agitation pour faire réagir
(1) une résine dicyclopentadiène-phénolique (DCPD_PN) de formule 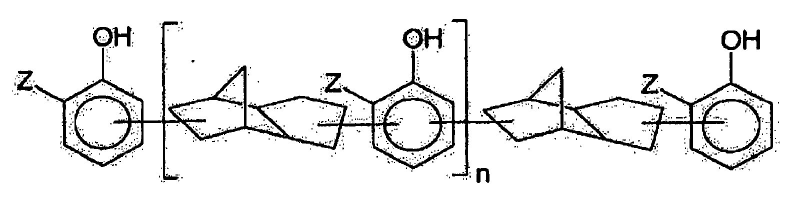 dans laquelle
Z est -CH₃, -C₂H₅, -C(CH₃)₃ ou, -H; et
n est de 0,5 à 1,5 ;
(2) un composé d'amine primaire avec des groupes monofonctionnels et bifonctionnels mixtes ; et
(3) un composé de formaldéhyde ou de paraformaldéhyde ;
où la résine de dicyclopentadiène-dihydrobenzoxazine (DCPD-BX) a la formule structurale : 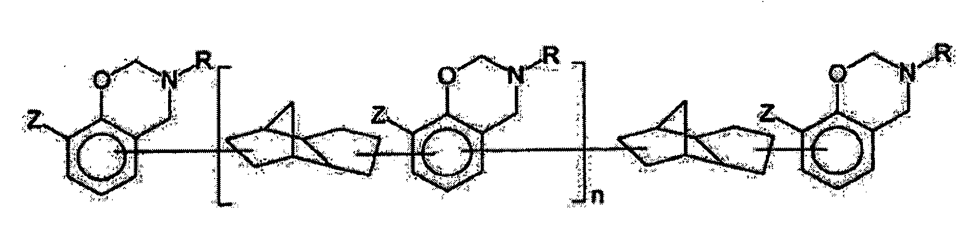 dans laquelle
Z est -CH₃, -C₂H₅, -C(CH₃)₃ ou, -H ;
R est alkyle ou aryle ; et
n est 0 à 1 ; et
où lesdites résines dicyclopentadiéne-phénoliques (DCPD-PNE) sont préparées par réaction de
(1) une résine dicyclopentadiène-phénolique (DCPD-PN) de formule 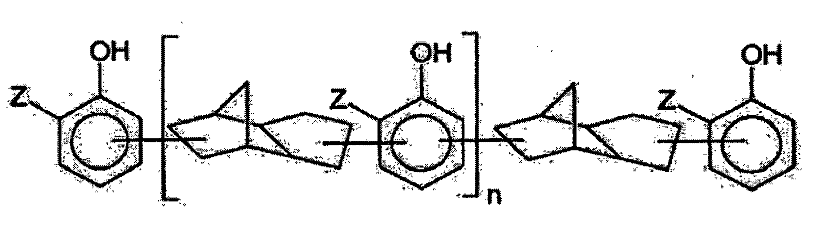 dans laquelle
Z est -CH₃, -C₂H₅, -C(CH₃)₃ ou, -H ; et
n est 0, 5 à 1, 5 ; avec
(2) l'épichlorhydrine ;
où les résines époxy dicyclopentadiène-phénoliques (DCPD-PNE) ont la formule structurale : 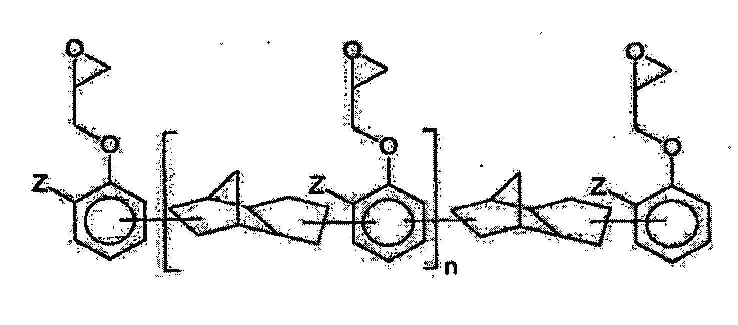 dans laquelle
Z est -CH₃, -C₂H₅, -C(CH₃)₃, ou -H ; et n est 0 à 2.

2. Composition de vernis de résine à faible constante diélectrique pour stratifiés selon la revendication 1, dans laquelle le dicyclopentadiène utilisé pour produire la résine dicyclopentadiène-phénolique (DCPD-PN) est un sous-produit de craquage de naphta ; et les composés phénoliques sont choisis parmi le phénol, le o-crésol, le bisphénol (Bisphénol-A), le 4,4'-diphénylméthane (Bisphénol-F), la 4,4-diphénylsulfone (Bisphénol-S) ou une résine phénolique.

3. Composition de vernis de résine à faible constante diélectrique pour stratifiés selon la revendication 1, dans laquelle l'agent de durcissement est une résine dicyclopentadiène-phénolique (DCPD-PN).

4. Composition de vernis de résine à faible constante diélectrique pour stratifiés selon la revendication 1, dans laquelle la résine d'agent de durcissement peut être choisie parmi une résine phénolique, des amines, des acides organiques et des agents de durcissement de type anhydride d'acide.

5. Composition de vernis de résine à faible constante diélectrique pour stratifiés selon la revendication 4, dans laquelle la résine d'agent de durcissement est choisie dans le groupe constitué d'amines polyvalentes, acide carboxylique polyvalent, dicyanodiamide, anhydride, résine de phénol-formaldéhyde (Phenol Novolac, appelée PN), résine de o-crésol-formaldéhyde (Cresol Novolac, appelée CN), résine de mélamine-phénol-formaldéhyde (Melamine Phenol Novolac, MPN), résine de bisphénol-formaldéhyde (BPA Phenol Novolac, BPA-PN), résine de tétraphénoléthane (TetraPhenol Novolac, TPN) et résine dicyclopentadiène-phénolique (Dicyclopentadiene-Phenolic Novolac, DCPD-PN).

6. Composition de vernis de résine à faible constante diélectrique pour stratifiés selon la revendication 1, la composition comprenant la résine de dicyclopentadiène-dihydrobenzoxazine (DCPD-BX) ou la résine hybride d'une ou plusieurs résines époxy dicyclopentadiène-phénoliques (DCPD-PNE) et une résine de dicyclopentadiène-dihydrobenzoxazine (DCPD-BX) seule ou en mélange avec d'autres résines époxy.

7. Composition de vernis de résine à faible constante diélectrique pour stratifiés selon la revendication 6, dans laquelle le composé d'amine primaire avec des groupes monofonctionnels et bifonctionnels mixtes utilisé dans la production de résine de dicyclopentadiène-dihydrobenzoxazine (DCPD-BX) est un composé d'amine aliphatique ou aromatique.

8. Composition de vernis de résine à faible constante diélectrique pour stratifiés selon la revendication 7, dans laquelle le composé d'amine primaire est une amine primaire telle que la méthylamine, l'aniline, la o-toluidine ou l'anisidine.

9. Composition de vernis de résine à faible constante diélectrique pour stratifiés selon la revendication 6, dans laquelle le composé de formaldéhyde ou de paraformaldéhyde utilisé pour la préparation de la résine de dicyclopentadiène-dihydrobenzoxazine (DCPD-BX) est choisi parmi le formaldéhyde, le paraformaldéhyde, ou la vapeur de formaldéhyde.

10. Composition de vernis de résine à faible constante diélectrique pour stratifiés selon la revendication 6, dans laquelle les autres résines époxy comprennent une résine époxy bromée ou une résine époxy phosphorée.

11. Composition de vernis de résine à faible constante diélectrique pour stratifiés selon la revendication 1, dans laquelle l'agent ignifugeant est une résine bromée ou phosphorée, ou un agent ignifugeant de charge inorganique.

12. Composition de vernis de résine à faible constante diélectrique pour stratifiés selon la revendication 11, dans laquelle
(1) l'agent ignifugeant bromé est une résine époxy de type tétrabromobisphénol (TBBA) ou tétrabromobisphénol, ou
(2) les agents ignifugeants phosphorés sont le 10-oxide de 9,10-dihydro-9-oxa-10-phosphaphénanthrène (DOPO), la DOPO-hydroquinone (DOPO-HQ) et sa résine époxy phénolique, ou
(3) les agents ignifugeants de charge inorganique sont choisis parmi l'hydroxyde d'aluminium, la silice, le sulfate de baryum, l'oxyde d'aluminium et le nitrure de bore.

13. Composition de vernis de résine à faible constante diélectrique pour stratifiés selon la revendication 1, dans laquelle l'accélérateur de durcissement est un composé ou un mélange de deux composés ou plus et représente de 0,04 à 0,15 partie pour cent de résine de la résine totale.

14. Composition de vernis de résine à faible constante diélectrique pour stratifiés selon la revendication 1, dans laquelle l'accélérateur de durcissement est choisi parmi des composés d'imidazole.

15. Composition de vernis de résine à faible constante diélectrique pour stratifiés selon la revendication 1, dans laquelle l'accélérateur de durcissement est choisi parmi le 2-méthyl-imidazole (2MI) et le 2-éthyl-4 méthylimidazole (2E4MZ).
